(19) Europäisches Patentamt
European Patent Office
Office européen des brevets

(11) **EP 3 360 222 B1**

(12) **FASCICULE DE BREVET EUROPEEN**

(45) Date de publication et mention de la délivrance du brevet:
**19.08.2020 Bulletin 2020/34**

(21) Numéro de dépôt: **16790657.7**

(22) Date de dépôt: **04.10.2016**

(51) Int Cl.:
*H02J 3/01* *(2006.01)*      *H02J 13/00* *(2006.01)*

(86) Numéro de dépôt international:
**PCT/FR2016/052540**

(87) Numéro de publication internationale:
**WO 2017/060606 (13.04.2017 Gazette 2017/15)**

(54) **DÉTERMINATION D'UNE POLLUTION HARMONIQUE SUR UN RÉSEAU DE DISTRIBUTION D'ÉNERGIE ÉLECTRIQUE**

BESTIMMUNG DER OBERSCHWINGUNGSBELASTUNG ÜBER EIN ELEKTRISCHES VERTEILUNGSNETZ

DETERMINATION OF HARMONIC POLLUTION OVER AN ELECTRICAL DISTRIBUTION NETWORK

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **06.10.2015 FR 1559507**

(43) Date de publication de la demande:
**15.08.2018 Bulletin 2018/33**

(73) Titulaire: **Universite De Poitiers**
**86000 Poitiers (FR)**

(72) Inventeur: **RAMBAULT, Laurent**
**86180 Buxerolles (FR)**

(74) Mandataire: **Novagraaf Technologies**
**Bâtiment O2**
**2, rue Sarah Bernhardt**
**CS90017**
**92665 Asnières-sur-Seine Cedex (FR)**

(56) Documents cités:
**WO-A1-2012/000510      WO-A1-2013/057416**
**JP-B2- 3 037 477      JP-B2- 3 037 477**

- **FEI QI ET AL: "Research on the responsibility partition of harmonic pollution and harmonic impedance based on the total least-squares regression method", 2014 INTERNATIONAL CONFERENCE ON POWER SYSTEM TECHNOLOGY, IEEE, 20 octobre 2014 (2014-10-20), pages 2122-2127, XP032712132, DOI: 10.1109/POWERCON.2014.6993568**

**Description**

DOMAINE DE L'INVENTION

L'invention concerne la détection d'une pollution harmonique au sein d'un réseau de distribution d'énergie électrique. Elle permet non seulement de détecter la présence d'une pollution harmonique, mais d'en fournir une mesure et, selon un mode de réalisation, de déterminer une localisation de cette pollution harmonique.

CONTEXTE DE L'INVENTION

Une réseau de distribution d'énergie électrique (ou plus simplement « réseau électrique ») véhicule en théorie l'énergie électrique sous la forme d'une sinusoïde ayant une fréquence fixe, en France de 50 Hz, depuis des centres de production vers des consommateurs. Ces consommateurs peuvent être des particuliers, disposant d'un nombre limité d'équipements, eux-mêmes de dimensions limitées, ou des établissements industriels qui peuvent disposer d'un très grand nombre d'équipements et avoir des besoins en consommation électrique très important.

Certains équipements peuvent perturber ce signal et créer une distorsion harmonique. D'une façon générale, ces équipements sont installés chez le consommateur et le gestionnaire du réseau de distribution ne peut pas avoir de contrôle sur eux.

Cette distorsion harmonique est provoquée par des charges non-linéaires connectées au réseau électrique, qui induisent des composantes harmoniques du signal. Ces charges non-linéaires peuvent être dues à des équipements mal réglés, défectueux, mal conçus... mais aussi certains types d'équipements ont nativement de telles charges non-linéaires, comme par exemple les LED (« Light Emitting Diode »), les alimentations des appareils électroménagers, les variateurs de vitesse pour les moteurs électriques, etc.

On estime aujourd'hui que l'énergie correspondant à ces perturbations harmoniques correspond à environ 5% de l'énergie totale. Du fait de l'augmentation du nombre d'équipements ayant nativement une charge non-linéaire, ce chiffre devrait croitre de façon significative dans le futur.

Un inconvénient important de la perturbation harmonique provient du fait qu'elle se propage à travers l'ensemble du réseau de distribution électrique, et ne reste nullement donc cantonnée au réseau privé du consommateur.

Or, certains équipements peuvent y être très sensibles et voir leur fonctionnement perturbé, voire être endommagés, par ce phénomène. C'est par exemple le cas des télévisions, etc. qui peuvent avoir une espérance de vie sensiblement diminuée du fait des perturbations harmoniques sur le réseau électrique.

En outre, les mécanismes de mesure de consommation électrique effectuées au moyen de compteurs par les gestionnaires des réseaux de distribution sont basés sur le fondamental. Autrement dit, uniquement l'énergie correspondant à la fréquence de 50 Hz, pour la France, est prise en compte pour déterminer la consommation d'un consommateur. L'énergie correspondant aux fréquences harmoniques n'est pas pris en compte et ne peut donc être facturée aux consommateur, ce qui correspond à une perte d'environ 5%.

La meilleure maitrise des perturbations harmoniques est donc un enjeu crucial pour les gestionnaires de réseaux de distribution d'énergie électriques.

Les solutions existantes se basent principalement sur des filtres anti-harmoniques, qui permettent de filtrer les fréquences différentes et multiples de la fréquence fondamentale.

Toutefois, ces solutions ne permettent pas de déterminer la source de la pollution harmonique. Il convient donc de placer des filtres au niveau de chaque connexion de consommateurs afin de garantir la non-propagation des perturbations locales.

Une telle solution est évidemment coûteuse mais est imparfaite, car un filtrage efficace soit être basé sur la connaissance de la nature et d'une estimation de la pollution harmonique.

Les solutions actuelles, notamment les solutions de filtrage, se basent sur une modélisation du réseau électrique située chez les consommateurs. À l'aide de cette modélisation, il est possible d'estimer comment supprimer ou substantiellement réduire les énergies correspondant aux fréquences harmoniques au niveau du filtre.

Il est toutefois très difficile de modéliser un réseau de consommateur, du fait de la disparité entre les consommateurs, mais aussi, et surtout, de la nature dynamique de la charge connectée à un réseau électrique. En fonction des heures de la journée, les équipements connectés et allumés peuvent fortement variés, et même d'une minute à l'autre, la charge connectée peut connaître des variations très importantes.

Aussi, une solution basée sur la modélisation des réseaux électriques des consommateurs ne peut être, par essence, que très insuffisante.

Un exemple d'une telle solution basée sur la modélisation est décrite dans l'article « Research on the Responsability Partition of Harmonie Pollution and Harmonie impedance Based on the Total Least-squares Régression Method » de Qi Fei, Li Jian-Wen, Li Yong-gang, Sun Wei et Li Zhong-Jian. Cette approche souffre des inconvénients cités ci-dessus, à savoir la non prise en compte de la nature dynamique du réseau électrique des consommateurs.

En outre, elle ne permet pas de localiser une source de pollution. En effet, cette solution vise à déterminer si un réseau de consommateur subit une pollution harmonique, mais ne permet pas de déterminer si cette pollution harmonique est le fait du réseau de ce consommateur ou bien si elle provient d'un autre consommateur via le réseau de distribution.

Ne permettant pas de localiser la source de la pollution harmonique, elle ne permet pas de mettre en œuvre des contremesures pleinement efficaces.

RÉSUMÉ DE L'INVENTION

Le but de la présente invention est de fournir une méthode et un système palliant au moins partiellement les inconvénients précités.

A cette fin, la présente invention propose, selon un premier aspect, un procédé pour la détection d'une pollution harmonique au sein d'un réseau de distribution électrique transmettant un courant, comportant

- Une étape de mesure d'au moins une tension et au moins une intensité dudit courant, pour chacune desdites phases, à un point de comptage dudit réseau ;
- Une étape de calcul d'une première impédance de type quaternion correspondant à la fréquence fondamentale dudit courant,
- Une étape de calcul d'au moins une seconde impédance de type quaternion correspondant à une fréquence harmonique dudit courant ;
   lesdites impédances, Zr, Zi, étant calculées en transformant lesdites tensions et intensités dans un repère bidimensionnel défini selon un angle dépendant de ladite fréquence afin de fournir un système de 2 vecteurs de 3 quantités, ud, uq, uo et id, iq, io, respectivement, puis, après utilisation d'une notation en quaternions, en appliquant les expressions :

pour la partie réelle,

$$Z_r = \frac{u_d \times i_d + u_q \times i_q}{i_d \times i_d + i_q \times i_q}$$

pour la partie imaginaire :

$$Zi = \frac{u_q \times i_d + u_d \times i_q}{i_d \times i_d + i_q \times i_q}$$

- Une étape de détermination d'une pollution harmonique en fonction de la différence entre ladite première impédance et ladite au moins une seconde impédance.

Suivant des modes de réalisation préférés, l'invention comprend une ou plusieurs des caractéristiques suivantes qui peuvent être utilisées séparément ou en combinaison partielle entre elles ou en combinaison totale entre elles :

- ledit courant est triphasé, ladite étape de mesure consiste à mesurer des tensions et intensités pour les trois phases, et ledit repère bidimensionnel est constitué des deux premières dimensions d'un repère de Park ;
- ledit courant est monophasé et ledit repère bidimensionnel est défini par les équations :

$$\begin{cases} u_d = V \times \sin(\theta) \\ u_q = V \times \cos(\theta) \end{cases}$$

$$\begin{cases} i_d = I \times \sin(\theta) \\ i_q = I \times \cos(\theta) \end{cases}$$

- ladite fréquence harmonique est la fréquence harmonique d'ordre 5 ;
- ladite au moins une seconde impédance correspond aux fréquences harmoniques d'ordre parmi les ordres 5, 7, 11, 13, 17, 19, 23.

Un autre aspect de l'invention concerne un compteur adapté pour la détection d'une pollution harmonique au sein d'un réseau de distribution électrique transmettant un courant, comportant

- Des moyens de mesure des tensions et intensités dudit courant, pour chacune desdites phases, à un point de comptage dudit réseau ;
- Des moyens de calcul d'une première impédance de type quaternion correspondant à la fréquence fondamentale dudit courant,
- Des moyens de calcul d'au moins une seconde impédance de type quaternion correspondant à une fréquence harmonique dudit courant ;
  lesdites impédances étant calculées en transformant lesdites tensions et intensités dans un repère bidimensionnel défini selon un angle dépendant de ladite fréquence afin de fournir un système de 2 vecteurs de 3 quantités, ud, uq, uo et id, iq, io, respectivement, puis, après utilisation d'une notation en quaternions, en appliquant les expressions :

pour la partie réelle,

$$Z_r = \frac{u_d \times i_d + u_q \times i_q}{i_d \times i_d + i_q \times i_q}$$

pour la partie imaginaire :

$$Zi = \frac{u_q \times i_d + u_d \times i_q}{i_d \times i_d + i_q \times i_q}$$

- Des moyens de détermination d'une pollution harmonique en fonction de la différence entre ladite première impédance et ladite au moins une seconde impédance.

Suivant des modes de réalisation préférés, l'invention comprend une ou plusieurs des caractéristiques suivantes qui peuvent être utilisées séparément ou en combinaison partielle entre elles ou en combinaison totale entre elles :

- lequel ledit courant est triphasé, ladite étape de mesure consiste à mesurer des tensions et intensités pour les trois phases, et ledit repère bidimensionnel est constitué des deux premières dimensions d'un repère de Park ;
- ledit courant est monophasé et ledit repère bidimensionnel est défini par les équations :

$$\begin{cases} u_d = V \times \sin(\theta) \\ u_q = V \times \cos(\theta) \end{cases}$$

$$\begin{cases} i_d = I \times \sin(\theta) \\ i_q = I \times \cos(\theta) \end{cases}$$

- ladite fréquence harmonique est la fréquence harmonique d'ordre 5 ;
- ladite au moins une seconde impédance correspond aux fréquences harmoniques d'ordre parmi les ordres 5, 7, 11, 13, 17, 19, 23.

Un autre aspect de l'invention concerne un réseau de distribution électrique comportant au moins un compteur tel que précédemment défini.

Selon un mode de réalisation, ce réseau de distribution peut comporter une pluralité de branches de distribution entre un poste d'entrée et des consommateurs, et un compteur associé à chacun desdits consommateurs, afin de déterminer le ou les consommateurs à l'origine d'une pollution harmonique.

Un autre aspect de l'invention concerne un système comportant un compteur tel que précédemment défini et un filtre anti-harmonique, dans lequel ladite pollution harmonique déterminée par le compteur permet de configurer dynamiquement le filtre.

Ainsi, la solution proposée permet non seulement de déterminer qu'une pollution harmonique existe mais aussi elle peut permettre de la quantifier.

D'autres caractéristiques et avantages de l'invention apparaîtront à la lecture de la description qui suit d'un mode de réalisation préféré de l'invention, donnée à titre d'exemple et en référence aux dessins annexés.

BRÈVE DESCRIPTION DES DESSINS

La figure 1 représente schématiquement un exemple de réseau de distribution d'énergie électrique avec un déploiement de l'invention selon un mode de réalisation de l'invention.

La figure 2 représente schématiquement une vue fonctionnelle du procédé d'un mode de réalisation de l'invention.

DESCRIPTION DÉTAILLÉE DE L'INVENTION

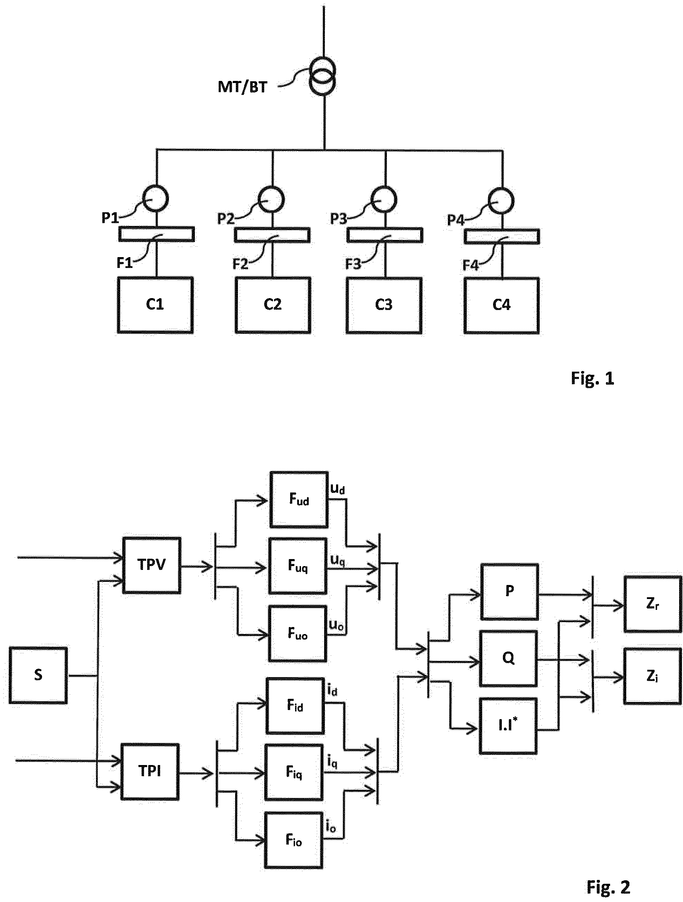

La figure 1 schématise un réseau de distribution permettant d'alimenter 4 consommateurs, ou clients, C1, C2, C3, C4 en basses tensions triphasées.

Un poste d'entrée à ce segment terminal d'un réseau de distribution peut être un convertisseur MT/BT qui permet d'abaisser la tension d'une moyenne tension (par exemple 20 kV) vers une basse tension (par exemple 400 V). Des points de comptage P1, P2, P3, P4 sont associés à chaque consommateurs, C1, C2, C3, C4 respectivement. Ils peuvent être situés en entrée du réseau électrique privé des consommateurs, afin de compter la consommation électrique du client associé.

Selon un mode de réalisation de l'invention, ces points de comptage, ou compteurs, sont adaptés pour déterminer une quantité de pollution harmonique sur le réseau électrique générée par les consommateurs.

L'invention permet ainsi de localiser une pollution harmonique. Il est en effet à noter que puisque une pollution harmonique se propage sur le réseau de distribution, certaines méthodes consistant à mesurer la pollution harmonique chez un consommateur peuvent mesurer une pollution provenant d'un autre consommateur. De telles méthodes ne peuvent donc pas permettre d'action corrective efficace

Autrement dit, il est primordial de non seulement être en mesure de mesurer une pollution harmonique mais encore de la localiser, c'est-à-dire de déterminer le réseau de consommation qui en est à l'origine.

Un point de comptage supplémentaire P5 situé à proximité du convertisseur MT/BT peut également être adapté à déterminer une quantité de pollution harmonique. Selon l'invention, la quantité déterminée par ce point de comptage supplémentaire P5 est la somme des quantités déterminées par les points de comptage P1, P2, P3, P4.

Ainsi, l'invention peut permettre de déterminer les consommateurs provoquant la pollution harmonique la plus importante. Les mesures de pollution fournies par les points de comptage P1, P2, P3, P4 peut permettre par exemple de paramétrer les filtres F1, F2, F3, F4 respectivement. Ainsi, les filtres anti-harmoniques peuvent être dynamiquement configurés par des mesures représentatives de la charge non-linéaire connectée au réseau des consommateurs.

La pollution harmonique peut ainsi être fortement réduite, voire totalement supprimée sur le réseau de distribution. La pollution harmonique générée sur le réseau privé d'un consommateur reste ainsi cantonnée sur ce réseau privée et ne perturbe pas les autres consommateurs. Il n'y en outre pas d'effet d'accumulation, les perturbations harmoniques de chaque consommateur ne se superposant plus.

De surcroit, le gestionnaire du réseau de distribution peut avoir une mesure précise de la pollution de chaque consommateur. Cette mesure peut lui permettre de déclencher une action corrective individualisée si, par exemple, la pollution dépasse un seuil donné. En effet, un niveau de pollution harmonique peut être jugé acceptable, notamment si elle peut être aisément annihilée par un filtre anti-harmonique, mais certains niveaux élevés de pollution harmonique peuvent nécessiter une intervention particulière.

Enfin, la connaissance du niveau quantifié de pollution harmonique peut permettre de déduire la consommation électrique réelle des consommateurs. En effet, il est alors possible de connaître l'énergie consommée correspondant à chacune des fréquences harmoniques, ou bien aux fréquences harmoniques principales et donc l'énergie totale.

Selon l'invention, la détermination d'une pollution harmonique est effectuée en fonction de la différence entre une première impédance, mesurée pour la fréquence fondamentale, et au moins une seconde impédance mesurée pour une fréquence harmonique (distincte nécessairement de la fréquence du fondamental).

Cette différence peut fournir en outre une métrique d'un niveau de pollution. On peut ainsi obtenir une mesure du niveau de pollution harmonique par harmonique, et, après agrégation, un niveau global de pollution harmonique.

Typiquement, l'harmonique d'ordre 5 est celle ayant le plus d'impact sur la pollution globale. En France, le fondamental étant à 50 Hz, cette harmonique d'ordre 5 correspond à une fréquence de 250 Hz. En effet, l'harmonique d'ordre 3 correspond à un déséquilibre des trois phases, qui est une anomalie de l'installation électrique qui peut être corrigée. L'harmonique d'ordre 5 correspond aujourd'hui à environ 5% de l'énergie totale véhiculée sur le réseau de distribution. L'harmonique d'ordre 7 correspond à une énergie inférieure à 1% de l'énergie totale. Il n'y a pas d'énergie correspondant aux harmoniques d'ordre pair.

Par conséquent, la détermination de la distorsion pour l'harmonique d'ordre 5 peut être suffisante pour fournir une bonne estimation de la pollution harmonique globale. Alternativement, il peut être possible de prendre en compte les harmoniques d'ordre 5 et 7, ou 5, 7 et 11, ou bien encore un nombre quelconque d'harmoniques parmi les ordre 5, 7, 11, 13, 17, 19, 23... afin de fournir une estimation plus précise de la pollution harmonique globale.

Tout d'abord, la tension et l'intensité sont mesurés sur un point de comptage.

Cette mesure est effectuée pour les trois phases, fournissant ainsi deux vecteurs à trois composantes :
V=[V1, V2, V3], pour la tension, et,
I=[I1,I2,I3], pour l'intensité du courant.

Puis, selon l'invention, on calcule une première impédance correspondant à la fréquence fondamentale du courant.

D'une façon générale, le procédé selon l'invention comprend pour ce faire la transformation des tensions et intensité mesurés dans un repère bidimensionnel défini selon un angle qui dépend à une fréquence considérée.

Selon un premier mode de réalisation décrit, le courant électrique courant électrique triphasé.

Dans ce cas, cette impédance est calculée en transformant les tensions V et les intensités I dans un repère de Park, ou de type Park, selon une vitesse angulaire qui dépend de cette fréquence fondamentale.

Cette transformée de Park permet de transformer un vecteur à trois dimensions, dans un espace mathématique à deux dimensions. D'autres transformées possèdent des propriétés similaires à la transformée de Park, comme par exemple la transformée DQO (pour « Direct Quadrature Zéro » en langue anglaise).

Ainsi, le vecteur de l'intensité du courant I=[I1, I2, I3] peut fournir une intensité $i_{dqo}$ selon la transformée de Park, selon l'équation suivante :

$$i_{dqo} = P \cdot I = \frac{2}{3} \cdot \begin{bmatrix} \cos(\theta) & \cos\left(\theta - \frac{2\pi}{3}\right) & \cos\left(\theta + \frac{2\pi}{3}\right) \\ -\sin(\theta) & -\sin\left(\theta - \frac{2\pi}{3}\right) & -\sin\left(\theta + \frac{2\pi}{3}\right) \\ \frac{1}{2} & \frac{1}{2} & \frac{1}{2} \end{bmatrix} \cdot \begin{bmatrix} I1 \\ I2 \\ I3 \end{bmatrix}$$

Ainsi, le vecteur de l'intensité du courant I=[I1, I2, I3] peut fournir une intensité $i_{dqo}$ selon la transformée DQO, selon l'équation suivante :

$$i_{dqo} = P \cdot I = \sqrt{\frac{2}{3}} \cdot \begin{bmatrix} \cos(\theta) & \cos\left(\theta - \frac{2\pi}{3}\right) & \cos\left(\theta + \frac{2\pi}{3}\right) \\ -\sin(\theta) & -\sin\left(\theta - \frac{2\pi}{3}\right) & -\sin\left(\theta + \frac{2\pi}{3}\right) \\ \frac{\sqrt{2}}{2} & \frac{\sqrt{2}}{2} & \frac{\sqrt{2}}{2} \end{bmatrix} \cdot \begin{bmatrix} I1 \\ I2 \\ I3 \end{bmatrix}$$

Des équations similaires peuvent être écrites pour la tensions V=[V1, V2, V3].

Ces deux transformées diffèrent uniquement par la 3e ligne de la matrice P de transformation. Or, dans le cadre de l'invention et comme il sera vu ultérieurement, cette 3e ligne n'est pas utilisée dans les calculs et n'est exposé ici qu'afin d'avoir une matrice inversible. Dès lors, l'invention peut utiliser différentes transformées qui seront ci-dessous nommées « transformée de Park » ou « transformée de type Park »

L'angle θ correspond à la fréquence considérée, selon une relation classique : θ=2πtf, dans laquelle t est le temps et f la fréquence considérée.

Selon l'invention, au moins deux fréquences sont à considérer : la fréquence du fondamental et une fréquence harmonique, par exemple la fréquence harmonique d'ordre 5. Aussi, les calculs exposés doivent être effectués pour ces au moins deux valeurs d'angle θ.

Selon une seconde mise en œuvre décrite de l'invention, le courant et la tension sont monophasés. Il s'agit là encore de se ramener à un repère à deux dimensions, défini par l'angle θ (et d'ainsi permettre des comparaisons comme il sera vu ultérieurement).

La transformation permettant de se ramener à un tel repère peut se décrire par les expressions :

$$\begin{cases} u_d = V \times \sin(\theta) \\ u_q = V \times \cos(\theta) \end{cases}$$

$$\begin{cases} i_d = I \times \sin(\theta) \\ i_q = I \times \cos(\theta) \end{cases}$$

dans lesquelles V et I représentent respectivement la tension et l'intensité en monophasé.

Cet angle θ peut se déterminer comme dans le cas d'un courant triphasé par l'équivalence : θ=2πtf, dans laquelle t est le temps et f la fréquence considérée.

On notera que dans les deux mises en œuvre décrites, les grandeurs déterminées, ud, uq, id, iq sont dépendantes du temps

A la suite de la détermination de ces 4 grandeurs, on peut déterminer les impédances en utilisant une notation en quaternions. Les impédances obtenues seront donc également de type quaternion.

Selon une notation en quaternions, il est possible d'écrire les deux vecteurs transformés sous la forme

$$V=v.\cos(\psi 1).K+v.\sin(\psi 1).L$$

$$I=i.\cos(\psi 2).K+i.\sin(\psi 2).L$$

dans laquelle K et L représentent deux directions perpendiculaires du plan.

La puissance apparente S, qui est définie par S=V.I* où I* représente la quantité conjuguée de l'intensité I., peut alors s'exprimer :

$$S= (v.\cos(\psi 1).K+v.\sin(\psi 1).L).(-i.\cos(\psi 2).K-i.\sin(\psi 2).L)$$

Soit:

$$S=vi.\cos(\psi 1-\psi 2)+vi.\sin(\psi 1-\psi 2).M$$

Dans lequel M est une direction perpendiculaire au plan formé par les directions K et L.

Cette expression fait apparaître deux termes P et Q définis par :

P=vi.cos(Ψ1-Ψ2), représentant la partie scalaire de la puissance apparente, c'est-à-dire la puissance active.

Q= vi.sin(Ψ1-Ψ2).M, représentant la partie vectorielle de la puissance apparente S, c'est-à-dire la puissance réactive.

On peut définir une impédance Z par Z=V/I

Dès lors S=V.I*=Z.I.I* et S=P+Q

On peut donc écrire l'équation suivante :

$$Z = \frac{P}{I^2} + \frac{Q}{I^2}$$

Selon l'invention, cette impédance Z est calculée pour au moins deux fréquences, celle du fondamental et une harmonique au moins.

La figure 2 illustre le procédé de l'invention de façon schématique et non limitative. Il s'agit d'une vue fonctionnelle du procédé de l'invention, qui peut être mise en œuvre selon différents moyens techniques.

Les blocs TPV et TPI représentent respectivement des transformées de Park pour la tension V et l'intensité I d'un courant mesuré en un point de comptage donné.

Le bloc S représente un générateur d'un signal sinusoïdal à la fréquence concerné. Selon l'invention, les étapes représentées par la figure 2 sont effectuées une première fois pour la fréquence fondamentale, puis au moins une deuxième fois à une fréquence harmonique. Par exemple une première exécution peut être effectuée à une fréquence $f_0=50$Hz, correspondant au fondamental en France, et une deuxième exécution à une fréquence $f_5=250$Hz, correspondant à l'harmonique d'ordre 5 en France.

Cette sinusoïde est fournie en entrées des deux blocs TPV et TPI afin de déterminer l'angle $\theta$ des matrices de transformation de Park :

$$\theta_0 = 2\pi t f_0$$

$$\theta_5 = 2\pi t f_5$$

Les sorties des blocs TPV et TPI sont respectivement une tension $u_{dpo}$ et une intensité $i_{dpo}$, dans le repère de Park. Ces tension et intensité peuvent ensuite être transmises à des filtres $F_{ud}$, $F_{uq}$, $F_{uo}$, $F_{id}$, $F_{iq}$, et $F_{io}$. Ces filtres sont des filtres passe-bas permettant d'isoler la composante continue dans le repère de Park, c'est-à-dire la composante à la fréquence considérée. Les composantes de la tension $u_{dqo}$ peuvent être démultiplexées afin d'être traitées par des filtres spécifiques $F_{ud}$, $F_{uq}$, $F_{uo}$ pour chaque composante, respectivement $u_d$, $u_q$, $u_o$. De façon similaire, les composantes de l'intensité $i_{dqo}$ peuvent être démultiplexées afin d'être traitées par des filtres spécifiques $F_{id}$, $F_{iq}$, $F_{io}$ pour chaque composante, respectivement $i_d$, $i_q$, $i_o$.

Ces composantes $u_d$, $u_q$, $u_o$, $i_d$, $i_q$, $i_o$ sont ensuite fournies en entrées des blocs de calcul P, Q et I.I*. Ces blocs correspondent aux calculs des quantités P, Q et I.I* ($=I^2$) précédemment définies et qui correspondent à l'équation

$$Z = \frac{P}{I^2} + \frac{Q}{I^2}.$$

Ainsi, la quantité P qui correspond à la partie scalaire de la puissance apparente, c'est-à-dire la puissance active peut se calculer à partir des composantes fournies par l'expression :

$$P = u_d \times i_d + u_q \times i_q$$

La quantité Q qui représentante la partie vectorielle de la puissance apparente S, c'est-à-dire la puissance réactive peut se calculer à partir des composantes fournies par l'expression :

$$Q = u_q \times i_d + u_d \times i_q$$

Enfin, la quantité I.I* peut se calculer à partir des composantes fournies par l'expression :

$$I.I^* = i_d \times i_d + i_q \times i_q$$

Les 3 résultats de ces trois blocs de calculs fournissent les entrées des blocs de calcul $Z_r$ et $Z_i$ de l'étage suivant. Comme nous avons vu précédemment, l'impédance est fournie par :

$$Z = \frac{P}{I^2} + \frac{Q}{I^2}$$

Et on peut donc déterminer une impédance réelle $Z_r$ et une impédance imaginaire $Z_i$ selon

$$Z_r = \frac{P}{I^2} \text{ et } Z_i = \frac{Q}{I^2}$$

Ces impédances réelle et imaginaire peuvent également s'exprimer :

$$Z_r = \frac{u_d \times i_d + u_q \times i_q}{i_d \times i_d + i_q \times i_q}$$

$$Zi = \frac{u_q \times i_d + u_d \times i_q}{i_d \times i_d + i_q \times i_q}$$

Comme on a vu précédemment, les impédances réelle et imaginaire sont de type quaternions. La partie imaginaire de l'impédance représente la partie vectorielle selon un axe perpendiculaire au plan (d,q).

Ainsi l'invention comprend un première étape consistant à calculer les valeurs d'une première impédance $Z_r$, $Z_i$ pour la fréquence $f_0$ du fondamental du courant au point de comptage, une seconde étape consistant à calculer au moins une seconde impédance $Z_r$, $Z_i$ pour la fréquence $f_i$ d'une harmonique d'ordre i au même point de comptage et une étape de détermination d'une pollution harmonique en fonction de la différence entre la première impédance (pour la fréquence fondamentale) et une seconde impédance (pour la fréquence harmonique de rang i).

En effet, s'il existe une différence d'impédance entre des mesures à des fréquences différentes du courant, cela signifie que la charge ne se comporte pas de façon linéaire et qu'il y a donc une pollution harmonique engendrée par cette charge.

Une comparaison avec l'impédance de la charge à l'harmonique d'ordre i=5 peut suffire pour avoir une bonne estimation du comportement de la charge du réseau, mais il peut être choisi de considérer d'autres fréquences harmoniques afin d'affiner l'estimation.

En outre la valeur de la différence d'impédance $Z_r$, $Z_i$ peut fournir une indication d'un degré de pollution harmonique. Ce degré peut être comparé à un seuil afin de fournir une indication de pollution harmonique. Cette caractéristique permet de distinguer des pollutions mineures pour lesquels un gestionnaire de réseau de distribution peut ne pas souhaiter engendrer d'actions, et des pollutions plus importantes pour lesquels il souhaite au moins être informé.

L'invention présente plusieurs avantages importants par rapport à des solutions de l'état de la technique.

Tout d'abord, elle prend en compte le temps et permet donc de traiter les aspects dynamiques de la charge d'un réseau. Ainsi, un consommateur peut débrancher et rebrancher des équipements, la solution sera en mesure de déterminer sa pollution harmonique en temps réel, et sans qu'il soit bien sûr besoin de recalculer une modélisation de son réseau.

En outre, l'utilisation de la notation en quaternion permet de s'abstraire de l'influence des perturbations des autres consommateurs rattachés à un réseau de distribution. En effet, comme nous l'avons vu précédemment, les pollutions harmoniques d'un consommateur sont transmises via le réseau de distribution aux autres consommateurs qui y sont rattachés. Il est donc important de pouvoir isoler la pollution produite localement sur le point de mesure de celle provenant d'un autre consommateur via le réseau de distribution

Le caractère non linéaire de la charge est déterminé par des valeurs d'impédances (fréquence fondamentale et fréquences harmoniques) qui varient et ceci indépendamment d'un éventuelle courant non sinusoïdal. La caractérisation du caractère non linéaire, donc polluant, de la charge considérée permet d'évaluer la pollution sur un réseau électrique où l'ensemble des consommateurs forment un système interconnecté et couplé.

Chaque consommateur est à la fois source de pollution et victime de la pollution générée par les autres utilisateurs. Le modèle proposé permet de considérer uniquement la partie polluante d'un consommateur.

Il peut être prévu d'alimenter un filtre anti-pollution harmonique avec ces valeurs afin que celui-ci puisse être configurée et adaptée à la pollution harmonique effective. L'invention permet ainsi aux filtres de disposer de métriques réelles, correspondant au réseau de distribution, et non plus de modèles théoriques comme dans l'état de la technique.

Selon un mode de réalisation de l'invention, ce procédé peut être mis en œuvre de façon continue ou périodique, afin de disposer d'une estimation de la pollution harmonique dynamique, voire en temps réel. La configuration des filtres anti-harmoniques peut ainsi devenir dynamique, et ceux-ci peut s'adapter en temps réel aux changements de charge du réseau électrique d'un consommateur. Il s'agit là évidemment d'un avantage substantiel par rapport aux solutions de l'état de la technique.

Bien entendu, la présente invention n'est pas limitée aux exemples et au mode de réalisation décrits et représentés, mais elle est susceptible de nombreuses variantes accessibles à l'homme de l'art.

**Revendications**

1. Procédé pour la détection d'une pollution harmonique au sein d'un réseau de distribution électrique transmettant un courant électrique, comportant

   - Une étape de mesure d'au moins une tension et au moins une intensité dudit courant, pour chacune desdites phases, à un point de comptage (P1, P2, P3, P4) dudit réseau ;
   **caractérisé par**:

      - Une étape de calcul d'une première impédance de type quaternion correspondant à la fréquence fondamentale dudit courant,

   - Une étape de calcul d'au moins une seconde impédance de type quaternion correspondant à une fréquence harmonique dudit courant ;
   lesdites impédances étant calculées en transformant lesdites tensions et intensités dans un repère bidimensionnel défini selon un angle dépendant de ladite fréquence afin de fournir un système de 2 vecteurs de 3 quantités, ud, uq, uo et id, iq, io, respectivement, puis, après utilisation d'une notation en quaternions, en appliquant les expressions :

      pour la partie réelle,

      $$Z_r = \frac{u_d \times i_d + u_q \times i_q}{i_d \times i_d + i_q \times i_q}$$

      pour la partie imaginaire :

      $$Zi = \frac{u_q \times i_d + u_d \times i_q}{i_d \times i_d + i_q \times i_q}$$

      - Une étape de détermination d'une pollution harmonique en fonction de la différence entre ladite première impédance et ladite au moins une seconde impédance.

2. Procédé selon la revendication précédente, dans lequel ledit courant est triphasé, ladite étape de mesure consiste à mesurer des tensions et intensités pour les trois phases, et ledit repère bidimensionnel est constitué des deux premières dimensions d'un repère de Park.

3. Procédé selon la revendication 1, dans lequel ledit courant est monophasé et ledit repère bidimensionnel est défini par les équations :

$$\begin{cases} u_d = V \times \sin(\theta) \\ u_q = V \times \cos(\theta) \end{cases}$$

$$\begin{cases} i_d = I \times \sin(\theta) \\ i_q = I \times \cos(\theta) \end{cases}$$

**4.** Procédé selon l'une des revendications précédentes, dans lequel ladite fréquence harmonique est la fréquence harmonique d'ordre 5.

**5.** Procédé selon l'une des revendications 1 à 3, dans lequel ladite au moins une seconde impédance correspond aux fréquences harmoniques d'ordre parmi les ordres 5, 7, 11, 13, 17, 19, 23.

**6.** Compteur adapté pour la détection d'une pollution harmonique au sein d'un réseau de distribution électrique transmettant un courant triphasé, comportant

- Des moyens de mesure des tensions et intensités dudit courant, pour chacune desdites phases, à un point de comptage dudit réseau ;
**caractérisé par**:

Des moyens de calcul d'une première impédance de type quaternion correspondant à la fréquence fondamentale dudit courant,

- Des moyens de calcul d'au moins une seconde impédance de type quaternion correspondant à une fréquence harmonique dudit courant ;
lesdites impédances étant calculées en transformant lesdites tensions et intensités dans un repère bidimensionnel défini selon un angle dépendant de ladite fréquence afin de fournir un système de 2 vecteurs de 3 quantités, ud, uq, uo et id, iq, io, respectivement, puis, après utilisation d'une notation en quaternions, en appliquant les expressions :

pour la partie réelle,

$$Z_r = \frac{u_d \times i_d + u_q \times i_q}{i_d \times i_d + i_q \times i_q}$$

pour la partie imaginaire :

$$Zi = \frac{u_q \times i_d + u_d \times i_q}{i_d \times i_d + i_q \times i_q}$$

- Des moyens de détermination d'une pollution harmonique en fonction de la différence entre ladite première impédance et ladite au moins une seconde impédance.

**7.** Compteur selon la revendication précédente, dans lequel ledit courant est triphasé, ladite étape de mesure consiste à mesurer des tensions et intensités pour les trois phases, et ledit repère bidimensionnel est constitué des deux premières dimensions d'un repère de Park.

**8.** Compteur selon la revendication 6, dans lequel ledit courant est monophasé et ledit repère bidimensionnel est défini par les équations :

$$\begin{cases} u_d = V \times \sin(\theta) \\ u_q = V \times \cos(\theta) \end{cases}$$

$$\begin{cases} i_d = I \times \sin(\theta) \\ i_q = I \times \cos(\theta) \end{cases}$$

**9.** Compteur selon l'une des revendications 6 à 8, dans lequel ladite fréquence harmonique est la fréquence harmonique d'ordre 5.

10. Compteur selon l'une des revendications 6 à 8, dans lequel ladite au moins une seconde impédance correspond aux fréquences harmoniques d'ordre parmi les ordres 5, 7, 11, 13, 17, 19, 23.

11. Réseau de distribution électrique, comportant au moins un compteur selon l'une des revendications 6 à 10.

12. Réseau de distribution électrique selon la revendication précédente, comportant une pluralité de branches de distribution entre un poste d'entrée (MT/BT) et des consommateurs (C1, C2, C3, C4), et un compteur (P1, P2, P3, P4) associé à chacun desdits consommateurs, afin de déterminer le ou les consommateurs à l'origine d'une pollution harmonique.

13. Système comportant un compteur selon l'une des revendications 6 à 10 et un filtre anti-harmonique, dans lequel ladite pollution harmonique déterminée par ledit compteur permet de configurer dynamiquement ledit filtre.

**Patentansprüche**

1. Verfahren zur Bestimmung der Oberschwingungsbelastung innerhalb eines elektrischen Verteilungsnetzes, das elektrischen Strom überträgt, Folgendes beinhaltend

   - einen Schritt zum Messen mindestens einer Spannung und mindestens einer Intensität des Stroms für jede der Phasen an einem Zählpunkt (P1, P2, P3, P4) des Netzes;

   **gekennzeichnet durch**:

   - einen Schritt zum Berechnen einer ersten Impedanz vom Typ Quaternion, entsprechend der Grundfrequenz des Stroms,
   - einen Schritt zum Berechnen mindestens einer zweiten Impedanz vom Typ Quaternion, entsprechend der Oberschwingungsfrequenz des Stroms;
   wobei die Impedanzen durch Umwandeln der Spannungen und Intensitäten in einem zweidimensionalen Bezugspunkt berechnet werden, der gemäß einem Winkel definiert wird, der von der Frequenz abhängig ist, um ein System von 2 Vektoren von 3 Mengen, jeweils ud, uq, uo und id, iq, io bereitzustellen, danach, nach Verwendung einer Benotung in Quaternionen durch Anwenden der Ausdrücke:

   für das Realteil,

$$Z_r = \frac{u_d \times i_d + u_q \times i_q}{i_d \times i_d + i_q \times i_q}$$

   für das Imaginärteil:

$$Zi = \frac{u_q \times i_d + u_d \times i_q}{i_d \times i_d + i_q \times i_q}$$

   - einen Schritt zum Bestimmen einer Oberschwingungsbelastung in Abhängigkeit von der Differenz zwischen der ersten Impedanz und der mindestens einen zweiten Impedanz.

2. Verfahren nach dem vorstehenden Anspruch, wobei der Strom dreiphasig ist, wobei der Schritt zum Messen darin besteht, Spannungen und Intensitäten für die drei Phasen zu messen, und der zweidimensionale Bezugspunkt aus den beiden ersten Dimensionen eines Park-Bezugspunktes gebildet wird.

3. Verfahren nach Anspruch 1, wobei der Strom einphasig ist, und der zweidimensionale Bezugspunkt durch die folgenden Gleichungen definiert wird:

$$\begin{cases} u_d = V \times \sin(\theta) \\ u_q = V \times \cos(\theta) \end{cases}$$

$$\begin{cases} i_d = I \times \sin(\theta) \\ i_q = I \times \cos(\theta) \end{cases}$$

4. Verfahren nach einem der vorstehenden Ansprüche, wobei die Oberschwingungsfrequenz die Oberschwingungsfrequenz der Ordnung 5 ist.

5. Verfahren nach einem der Ansprüche 1 bis 3, wobei die mindestens eine zweite Impedanz den Oberschwingungsfrequenzen einer Ordnung aus der Ordnung 5, 7, 11, 13, 17, 19, 23 entspricht.

6. Zähler, der zur Erkennung einer Oberschwingungsbelastung innerhalb eines elektrischen Verteilungsnetzes, das einen dreiphasigen Strom überträgt, angepasst ist, Folgendes beinhaltend

- Mittel zum Messen mindestens der Spannungen und Intensitäten des Stroms für jede der Phasen an einem Zählpunkt des Netzes; **gekennzeichnet durch**:
- Mittel zum Berechnen einer ersten Impedanz vom Typ Quaternion, entsprechend der Grundfrequenz des Stroms,
- Mittel zum Berechnen mindestens einer zweiten Impedanz vom Typ Quaternion, entsprechend einer Oberschwingungsfrequenz des Stroms;
wobei die Impedanzen durch Umwandeln der Spannungen und Intensitäten in einem zweidimensionalen Bezugspunkt berechnet werden, der gemäß einem Winkel definiert wird, der von der Frequenz abhängig ist, um ein System von 2 Vektoren von 3 Mengen, jeweils ud, uq, uo und id, iq, io bereitzustellen, danach, nach Verwendung einer Benotung in Quaternionen durch Anwenden der Ausdrücke:

für das Realteil,

$$Z_r = \frac{u_d \times i_d + u_q \times i_q}{i_d \times i_d + i_q \times i_q}$$

für das Imaginärteil:

$$Zi = \frac{u_q \times i_d + u_d \times i_q}{i_d \times i_d + i_q \times i_q}$$

- Mittel zum Bestimmen einer Oberschwingungsbelastung in Abhängigkeit von der Differenz zwischen der ersten Impedanz und der mindestens einen zweiten Impedanz.

7. Zähler nach dem vorstehenden Anspruch, wobei der Strom dreiphasig ist, wobei der Schritt zum Messen darin besteht, Spannungen und Intensitäten für die drei Phasen zu messen, und der zweidimensionale Bezugspunkt aus den beiden ersten Dimensionen eines Park-Bezugspunktes gebildet wird.

8. Zähler nach Anspruch 6, wobei der Strom einphasig ist, und der zweidimensionale Bezugspunkt durch die folgenden Gleichungen definiert wird:

$$\begin{cases} u_d = V \times \sin(\theta) \\ u_q = V \times \cos(\theta) \end{cases}$$

$$\begin{cases} i_d = I \times \sin(\theta) \\ i_q = I \times \cos(\theta) \end{cases}$$

9. Zähler nach einem der Ansprüche 6 bis 8, wobei die Oberschwingungsfrequenz die Oberschwingungsfrequenz der Ordnung 5 ist.

10. Zähler nach einem der Ansprüche 6 bis 8, wobei die mindestens eine zweite Impedanz den Oberschwingungsfrequenzen einer Ordnung aus der Ordnung 5, 7, 11, 13, 17, 19, 23 entspricht.

11. Elektrisches Verteilungsnetz, mindestens einen Zähler nach einem der Ansprüche 6 bis 10 beinhaltend.

12. Elektrisches Verteilungsnetz nach dem vorstehenden Anspruch, das eine Vielzahl von Verteilungszweigen zwischen einer Eingangsstation (MT/BT) und den Verbrauchern (C1, C2, C3, C4) beinhaltet, und einen Zähler (P1, P2, P3, P4), der jedem der Verbraucher zugewiesen ist, um den oder die Verbraucher zu bestimmen, die eine Oberschwingungsbelastung begründen.

13. System, das einen Zähler nach einem der Ansprüche 6 bis 10 und ein Anti-Oberschwingungsfilter beinhaltet, wobei die von dem Zähler bestimmte Oberschwingungsbelastung es ermöglicht, das Filter dynamisch zu konfigurieren.


**Claims**

1. Procedure for detecting a harmonic pollution within an electricity distribution network transmitting an electrical current, comprising

   - A measurement step for at least one voltage and at least one magnitude of the said current, for each of the said phases, at a metering point (P1, P2, P3, P4) of the said network;

   **characterized by**:

   - A calculation step of a first quaternion-based impedance corresponding to the basic frequency of the said current;
   - A calculation step of at least one second quaternion-based impedance corresponding to a harmonic frequency of the said current;
   The said impedances are calculated by transforming the said voltages and magnitudes in a two-dimensional transform, defined according to an angle based on the said frequency in order to provide a system of 2 vectors of 3 quantities, ud, uq, uo and id, iq, io, respectively. Then, after using quaternion notation, by applying the expressions:

   For the real part:

$$Z_r = \frac{u_d \times i_d + u_q \times i_q}{i_d \times i_d + i_q \times i_q}$$

   For the imaginary part:

$$Zi = \frac{u_q \times i_d + u_d \times i_q}{i_d \times i_d + i_q \times i_q}$$

   - A determination step of a harmonic pollution based on the difference between the said first impedance and the said at least second impedance.

2. Procedure according to the above claim, wherein the said current is three-phased; the said measurement consists in measuring voltages and magnitudes for the three phases; and the said two-dimensional transform comprises the first two dimensions of a Park transform.

3. Procedure according to claim 1, wherein the said current is monophasic and the said two-dimensional transform is defined by the equations:

$$\begin{cases} u_d = V \times \sin(\theta) \\ u_q = V \times \cos(\theta) \end{cases}$$

$$\begin{cases} i_d = I \times \sin(\theta) \\ i_q = I \times \cos(\theta) \end{cases}$$

4. Procedure according to one of the prior claims, wherein the said harmonic frequency is the harmonic frequency of order 5.

5. Procedure according to one of the claims 1 to 3, wherein the said at least second impedance corresponds to the harmonic frequencies of the order among the orders 5, 7, 11, 13, 17, 19, 23.

6. Adapted meter for the detection of a harmonic pollution within an electricity distribution network transmitting a three-phase current, including

- Means for measuring the voltages and magnitudes of the said current, for each of the said phases, at a metering point of the said network;

**characterized by**:

- Means for calculating a first quaternion-based impedance corresponding to the basic frequency of the said current;
- Means for calculating at least a second quaternion-based impedance corresponding to a harmonic frequency of the said current;
The said impedances are calculated by transforming the said voltages and magnitudes in a two-dimensional transform defined according to an angle based on the said frequency in order to provide a system of 2 vectors of 3 quantities, ud, uq, uo and id, iq, io, respectively, then, after using a quaternion notation, applying the expressions:

For the real part:

$$Z_r = \frac{u_d \times i_d + u_q \times i_q}{i_d \times i_d + i_q \times i_q}$$

For the imaginary part:

$$Zi = \frac{u_q \times i_d + u_d \times i_q}{i_d \times i_d + i_q \times i_q}$$

- Means for determining a harmonic pollution based on the difference between the said first impedance and the said at least second impedance.

7. Meter according to the preceding claim, wherein the said current is three-phased, the said measurement step consists in measuring the voltages and magnitudes for the three phases, and the said two-dimensional transform is comprised of the two first dimensions of a Park transform.

8. Meter according to claim 6, wherein the said current is monophasic and the said two-dimensional transform is defined by the equations:

$$\begin{cases} u_d = V \times \sin(\theta) \\ u_q = V \times \cos(\theta) \end{cases}$$

$$\begin{cases} i_d = I \times \sin(\theta) \\ i_q = I \times \cos(\theta) \end{cases}$$

9. Meter according to one of the claims 6 to 8, wherein the said harmonic frequency is the harmonic frequency of order 5.

10. Meter according to one of the claims 6 to 8, wherein the said at least second impedance corresponds to the harmonic frequencies of an order among the orders 5, 7, 11, 13, 17, 19, 23.

11. Electricity distribution network, comprising at least one meter according to claims 6 to 10.

12. Electricity distribution network according to the preceding claim, comprising a plurality of distribution branches between an input terminal (MV/LV) and consumers (C1, C2, C3, C4) and a meter (P1, P2, P3, P4) associated to each of the said consumers, in order to determine the consumer(s) at the source of a harmonic pollution.

13. System including a meter according to one of the claims 6 to 10 and an anti-harmonic filter, wherein the said harmonic pollution determined by the said meter makes it possible to dynamically configure the said filter.

**Fig. 1**

**Fig. 2**

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Littérature non-brevet citée dans la description**

- **QI FEI ; LI JIAN-WEN ; LI YONG-GANG ; SUN WEI ; LI ZHONG-JIAN.** *Research on the Responsability Partition of Harmonie Pollution and Harmonie impedance Based on the Total Least-squares Régression Method*